(19) Europäisches Patentamt
European Patent Office
Office européen des brevets

(11) **EP 2 235 756 B1**

(12) **EUROPÄISCHE PATENTSCHRIFT**

(45) Veröffentlichungstag und Bekanntmachung des Hinweises auf die Patenterteilung:
**22.08.2018   Patentblatt 2018/34**

(21) Anmeldenummer: **08864609.6**

(22) Anmeldetag: **22.12.2008**

(51) Int Cl.:
*H01L 31/054* (2014.01)   *H01L 31/18* (2006.01)

(86) Internationale Anmeldenummer:
**PCT/EP2008/011041**

(87) Internationale Veröffentlichungsnummer:
**WO 2009/080354 (02.07.2009 Gazette 2009/27)**

(54) **REFLEKTIVE SEKUNDÄROPTIK UND HALBLEITERBAUGRUPPE SOWIE VERFAHREN ZU DESSEN HERSTELLUNG**

REFLECTIVE SECONDARY OPTIC, SEMICONDUCTOR ASSEMBLY AND METHOD FOR THE FABRICATION THEREOF

OPTIQUE SECONDAIRE RÉFLECTIVE ET MODULE SEMI-CONDUCTEUR AINSI QUE SON PROCÉDÉ DE FABRICATION

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **20.12.2007   EP 07024799**

(43) Veröffentlichungstag der Anmeldung:
**06.10.2010   Patentblatt 2010/40**

(73) Patentinhaber: **Fraunhofer-Gesellschaft zur Förderung der angewandten Forschung e.V.
80686 München (DE)**

(72) Erfinder:
• **JAUS, Joachim
79098 Freiburg (DE)**
• **BETT, Andreas
79114 Freiburg (DE)**
• **PASSIG, Michael
06420 Golbitz (DE)**
• **PEHARZ, Gerhard
79102 Freiburg (DE)**
• **NITZ, Peter
79194 Gundelfingen (DE)**
• **GRAF, Wolfgang
79427 Eschbach (DE)**

(74) Vertreter: **Pfenning, Meinig & Partner mbB
Patent- und Rechtsanwälte
Theresienhöhe 11a
80339 München (DE)**

(56) Entgegenhaltungen:
**EP-A1- 1 154 289        WO-A-2005/043627
WO-A1-03/048637        JP-A- 2005 175 389
US-A1- 2006 102 917        US-A1- 2007 126 020
US-A1- 2007 227 573**

EP 2 235 756 B1

**Beschreibung**

Vorliegende Erfindung betrifft eine reflektive oder eine reflektive und refraktive Sekundäroptik nach Anspruch 1 zur Fokussierung von Sonnenlicht auf Halbleiterbauelemente, wobei die Sekundäroptik erfindungsgemäß durch eine Auskragung gekennzeichnet ist, die um den die Sekundäroptik bildenden Grundkörper herum angeordnet ist. Weiterhin betrifft vorliegende Erfindung eine Halbleiterbaugruppe nach Anspruch 5, die die erfindungsgemäße Sekundäroptik umfasst, sowie ein Verfahren nach Anspruch 11 zur Herstellung dieser Halbleiterbaugruppe. Insbesondere stellt diese Halbleiterbaugruppe ein konzentrierendes Solarzellenmodul dar.

In der Konzentrator-Photovoltaik wird Licht mittels eines optischen Systems auf Solarzellen konzentriert. Hierzu wird z.B. eine Linse oder ein Fresnel-Kollektor verwendet, die das einfallende Licht auf die Solarzelle bündeln. Mehrere Solarzellen werden mit dem dazugehörigen optischen System, z.B. einem Linsenarray, sowie Bauelementen zur Kühlung und zur elektrischen Verschaltung zu Modulen zusammengebaut. Diese Module werden auf sog. Tracker montiert, auf denen sie dem Lauf der Sonne nachgeführt werden. Ein Beispiel einer Konzentrator-Photovoltaik-Vorrichtung wird in US 2007/227573 A1 offenbart. In der Konzentrator-Photovoltaik ist es von großem Interesse, dass möglichst viel des eingestrahlten Lichtes auf die Solarzelle trifft. Dies wird zum einen durch die Abbildungsqualität des optischen Systems beeinflusst, zum anderen durch die Genauigkeit, mit der das optische System zur Zelle sowie das Modul insgesamt zur Sonne ausgerichtet ist.

Ein weiterer wichtiger Gesichtspunkt in der Konzentrator-Photovoltaik ist der sog. Konzentrationsfaktor. Dieser gibt das Verhältnis der Lichteintrittsfläche der Optik zur aktiven Fläche der Solarzelle an. Um möglichst wenig der relativ teuren Solarzellenfläche einzusetzen, wird der Konzentrationsfaktor so groß wie möglich gewählt. Gerade bei hochkonzentrierenden Systemen bietet sich der Einsatz einer zweistufigen Optik an, deren beiden Elemente dann als Primäroptik (erstes optisches Element im Strahlengang, z.B. die Linse oder der Fresnel-Kollektor) bzw. Sekundäroptik (zweites Element) bezeichnet werden. Ein zweistufiges Konzept hat den Vorteil, dass die Strahlablenkung bei jedem einzelnen Element geringer ausfallen kann. Außerdem vergrößert sich der Gestaltungsspielraum beim Optik-Design deutlich, z.B. zur Verringerung der chromatischen Aberration oder zur Homogenisierung der Einstrahlung.

Die Sekundäroptik wird bisher meistens als refraktives Bauelement ausgeführt, bei dem die Lichtstrahlen durch interne Totalreflektion auf die Solarzelle gelenkt werden. Bekannt sind hier Elemente aus Glas in der Form eines Pyramidenstumpfes (US 5,505,789) oder aufwändigere Formen, die hauptsächlich auf Totalreflektion beruhen und im Spritzgussverfahren hergestellt werden (z.B. ES 2232299; V. Diaz, J. Alarez, J. Alonso et al., "Assembly of Concentrator Modules based on Silicon Solar Cells at 300x of Concentrated Sunlight", Proc. of 19th European Photovoltaic Solar Energy Conference, 2004). Um möglichst wenig Reflektion an der Austrittsfläche, verursacht durch große Unterschiede im Brechungsindex, zu erzielen, ist dieses Bauelement normalerweise über ein adhäsives und optisch transparentes Material, z.B. Silikon, direkt auf die Solarzelle montiert und an der Eintrittsapertur evtl. mit einer reflektionsmindernden Beschichtung versehen.

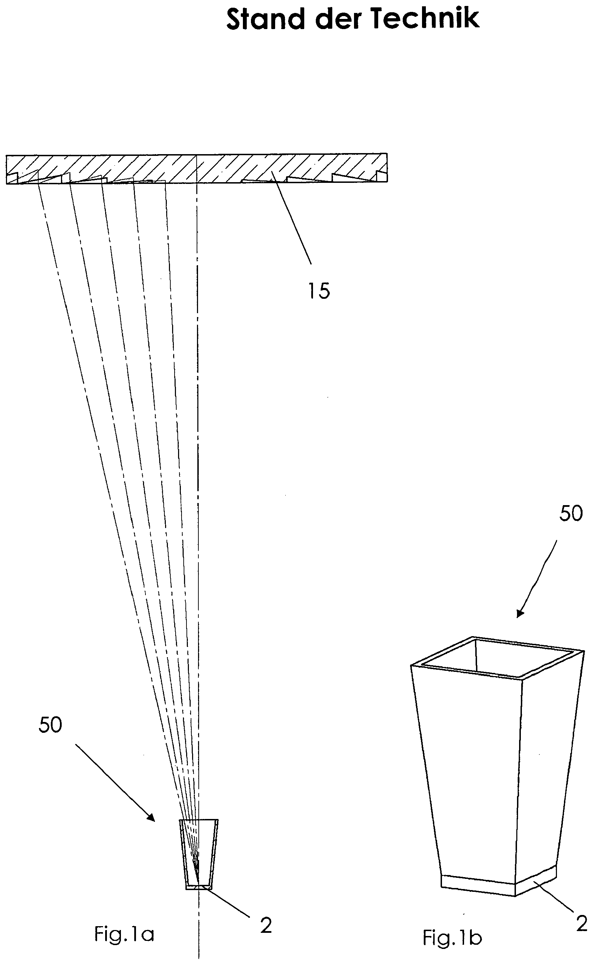

Gleichzeitig kommen auch einfache Sekundäroptiken zum Einsatz, die auf Reflektion an spiegelnden Oberflächen beruhen. In den bisher bekannten Anwendungen kommen hierzu trapezförmige metallene Körper oder runde Trichter zum Einsatz (siehe z.B. EP 0 657 948 A2; WO 91/18419; L. M. Fraas, "Line-Fokus Photovoltaic Module Using Stacked Tandem-Cells", 1994). Um die Reflektion dieser Bauteile zu erhöhen, werden die Bleche häufig vor der Umformung mit hoch reflektiven Schichten versehen. Derartige Aufbauten sind z.B. aus US 5,167,724 oder US 5,505,789 bekannt und illustrativ in Fig. 1 wiedergegeben. Dabei ist die Sekundäroptik 50 direkt auf der Solarzelle 2 angebracht. Das Sonnenlicht wird durch den Fresnel-Kollektor 15 auf die Sekundäroptik so vorfokussiert.

Weiterhin sind nach dem Stand der Technik Bauteile bekannt (WO 2004/077558 A1; DE 195 36 454 A1; DE 199 47 044 B4), die darauf ausgelegt sind, in Verbindung mit Halbleiterbauelementen eingesetzt zu werden, bei denen die Strahlung ganz oder teilweise an den Seitenflächen austritt oder empfangen wird. Diese seitliche Abstrahlung ist für LED-Halbleiterchips charakteristisch. Werden jedoch Halbleiterbauelemente verwendet, die fast ausschließlich mehr als 95 % der Strahlung zur Oberseite des Halbleiterchips aussenden oder empfangen, wie z.B. Solarzellen, so geht mit dem Reflektorkonzept nach diesen Patenten ein Teil der Strahlung verloren, da die Reflektoren darauf ausgelegt sind, dass der Halbleiterchip von oben in die Reflektorausformung hineingesetzt wird und damit sowohl Seitenwände als auch obere Kontaktierungsfläche im Strahlenlauf des Reflektors liegen. Bei dieser Bauform schließen die reflektierenden Bereiche den gesamten Halbleiterchip ein.

Aus DE 199 47 044 B4 ist z.B. ein Bauelement bekannt, bei dem der Sender und/oder Empfänger von einem metallischen Reflektor umgeben ist. Auch die aus dieser Druckschrift bekannte integrale Ausformung der Reflektorwände aus dem Leiterbandmaterial beruht auf dem Prinzip, dass der Chip in den Reflektor hineingesetzt werden kann, der Chip also kleiner ist als der kleinste Reflektordurchmesser/Reflektorquerschnitt.

Aus DE 195 36 454 A1 ist ebenfalls eine wannenförmige Ausbildung eines Reflektors bekannt, in die der Halbleiterchip hineingesetzt wird.

Aus WO 2004/077558 A1 ist ein Bauelement bekannt, bei dem durch Metallisierung eines Gehäusekörpers ein Reflektor realisiert wird. Auch hier ist der Halbleiterchip auf einen ersten Bereich der Metallisierung aufgebracht. Soll nur ein Teil der Chipfläche in der Austrittsapertur des Reflektors liegen, ist diese Bauform nicht geeignet.

Dieser Stand der Technik weist in Hinsicht auf die refraktiven Sekundäroptiken folgende Nachteile auf:

- Durch Absorption im Material der Sekundäroptik wird ein Teil des Lichtes absorbiert und steht damit nicht mehr für die Umwandlung in der Solarzelle zur Verfügung.
- Durch die Absorption des Lichts im Material heizt sich das Material stark auf, so dass es insbesondere bei hochkonzentrierenden Systemen zu einer Zerstörung der Sekundäroptik kommen kann.
- An der Eintrittsfläche der refraktiven Optik kommt es durch den großen Brechungsunterschied gegenüber der Umgebungsluft zu Reflektionen. Diese können zwar durch Antireflexschichten gemindert werden, diese erhöhen jedoch die Fertigungskosten und können Reflektionen nur verringern, nicht aber verhindern.
- Das Prinzip der Totalreflektion (total internal reflection, TIR) stellt sehr hohe Anforderungen an die Oberflächenqualität der Bauteile. Dies wirkt sich als starker Kostentreiber in der Produktion aus, da die bei hohen Stückzahlen favorisierten Fertigungsverfahren, wie Umformen oder Spritzgießen und die damit erreichbaren Oberflächenqualitäten häufig nicht ausreichen. Durch Schleifen lassen sich die Oberflächenqualitäten erzielen, dies ist in der hochvolumigen Fertigung jedoch ein relativ teurer Prozess, der sich nicht mit den zulässigen Kosten in der Konzentrator-Photovoltaik verträgt.
- Zur Vermeidung von Reflektionen ist der Raum zwischen Zelle und Sekundäroptik wie beschrieben mit einem optischen Medium ausgefüllt (siehe z.B. ES 2232299, US 5,505,789). Zur Minimierung von Lufteinschlüssen wird dieses Medium normalerweise in viskosem Zustand aufgetragen und nach Montage der Sekundäroptik ausgehärtet. Durch Kapillareffekte oder Benetzungseffekte kommt es jedoch häufig zur Benetzung der Außenwand der Sekundäroptik mit dem flüssigen Medium, wodurch der Wirkungsgrad der TIR herabgesetzt wird. Aufgrund der Oberflächenspannung des optischen Mediums kommt es im Bereich der Kanten der Sekundäroptik zur Bildung von charakteristischen Fugen, die ebenfalls zur Auskopplung von Licht und damit zur Verringerung des Wirkungsgrades führen.
- Da die Sekundäroptik prinzipbedingt die ganze Solarzellenfläche abdecken muss, müssen auch alle Strahlen, die auf die Solarzelle gelenkt werden sollen, vorher die Sekundäroptik durchlaufen. Dies führt jedoch bei den Strahlen, die auch ohne diese Optik auf die Zelle treffen würden, zu unnötigen Verlusten. Gerade bei sehr guten Primäroptiken trifft ein Großteil der Strahlen auch ohne Sekundäroptik auf die Zelle. Optimal ist in diesem Fall also eine Sekundäroptik, die ergänzend zur Primäroptik arbeitet und nur den Teil der Strahlen erfasst, der ohne weiteres Eingreifen nicht auf die Zelle treffen würde.

In Hinsicht auf die bisherigen Ausführungen von reflektiven Sekundäroptiken sind folgende Nachteile zu nennen:

- Die bekannten Sekundäroptiken sind schwierig zu Montieren, da es keine Elemente gibt, die das automatische Greifen erleichtern oder die Montage auf der Zelle vereinfachen.
- Die aus WO 91/18419, ES 2232299 oder WO 2006/130520 A2 bekannten Montageverfahren beruhen auf der Verwendung zahlreicher zusätzlicher Montage-Hilfsmittel, wie z.B. Schrauben, Rahmen oder Klemmbügel. Dies treibt die Material- und Prozesskosten in die Höhe und erhöht die Zahl der fehleranfälligen Komponenten und damit die Ausfallwahrscheinlichkeit des Gesamtsystems.
- In Bezug auf die Reflektoren für Halbleiterchips aus (WO 2004/077558 A1; DE 195 36 454 A1; DE 199 47 044 B4) ist der Hauptnachteil, dass die dort beschriebenen Bauteile dafür ausgelegt sind, dass der Halbleiterchip in eine reflektierende Ausformung gesetzt wird. Dadurch ist aber nur ein relativ undefinierter Strahlenverlauf realisierbar, je nach Ein-/Ausstrahlwinkel liegen auch die Seitenwände oder die Oberflächenmetallisierung im Strahlenverlauf.
- Da die Reflektionsschichten auf den Blechen im Umformprozess bei zu starker Umformung reißen, ist man in der Realisierungsmöglichkeit besonderer Geometrien stark eingeschränkt.
- Durch Absorption im Material können sich die Sekundäroptiken stark erhitzen. Bisher ist der Einsatz von speziellen Elementen zur Erhöhung der Wärmeabfuhr nur in einer Anmeldung dokumentiert (WO 91/18419), bei der die Wärmeabfuhr aber über eine aufwändig herzustellende zusätzliche Komponente realisiert wird.
- Die Spiegelschichten (z.B. Silber-basierte Schichtsysteme) weisen eine hohe Korrosionsanfälligkeit auf. Um dies zu verhindern, werden die reflektierenden Bleche mit einer Passivierungsschicht versehen. Da die Bauteile jedoch aus fertig beschichteten Blechbändern zugeschnitten werden, weisen die Schnittränder offen liegende Materialübergänge auf, an denen die Spiegelschichen nicht passiviert sind. Diese Schnittränder bilden im Betrieb Keimzellen für Korrosion.
- Weitere Nachteile sind bei den entsprechenden Patentzitaten in der Dokumentation zum Stand der Technik zu finden.

Der Erfindung liegt die Aufgabe zugrunde, ein optoelektronisches Bauteil, speziell ein Strahlung aussendendes oder empfangendes Halbleiterbauelement, derart weiterzubilden, dass die auszusendende oder zu empfangende Strahlung auf den Halbleiterchip gelenkt sowie die entstehende Wärme abgeführt wird. Die Erfindung bezieht sich dabei auf Aufgabenstellungen, bei denen Halbleiterchips eingesetzt werden, die Ihre Strahlung ausschließlich oder zu mehr als 90 % über die in Waferebene gelegenen Fläche aufnehmen/aussenden.

Es ist daher Aufgabe der vorliegenden Erfindung, eine reflektive und/oder refraktive Sekundäroptik bereitzustellen, die die im Voranstehenden genannten Nachteile überwindet. Ebenso ist es Aufgabe der Erfindung, eine Halbleiterbaugruppe bereitzustellen, die diese Sekundäroptik enthält.

Diese Aufgabe wird bezüglich der Sekundäroptik mit den Merkmalen des Anspruchs 1 und bezüglich der Halbleiterbaugruppe mit den Merkmalen des Anspruchs 5 gelöst. Mit Anspruch 11 wird ein Verfahren zur Herstellung der zuvor genannten Halbleiterbaugruppe angegeben. Die jeweiligen abhängigen Ansprüche stellen dabei vorteilhafte Weiterbildungen dar. Der Wortlaut der Ansprüche wird durch Inbezugnahme in die Beschreibung mit aufgenommen.

Erfindungsgemäß wird eine reflektive oder eine reflektive und refraktive Sekundäroptik zur Fokussierung von Sonnenlicht auf Halbleiterbauelemente, umfassend einen Reflektor mit einer dem Sonnenlicht zugewandten Eintrittsapertur (4) und einer dem Halbleiterbauteil zugewandten Austrittsapertur, wobei der Reflektor eine den Reflektor umschließende Auskragung aufweist, bereitgestellt.

Bevorzugte Ausführungsformen sehen vor, dass die Auskragung in Längsrichtung des Reflektors auf Höhe der Eintrittsapertur angeordnet ist und/oder monolithisch oder formschlüssig mit dem Reflektor verbunden ist und/oder planparallel zur Eintrittsapertur angeordnet ist und/oder einen Umriss aufweist, der rechteckig, quadratisch, kreisförmig, oval oder unregelmäßig geformt ausgebildet ist und/oder dass der Reflektor zumindest teilweise aus Materialien, ausgewählt aus der Gruppe bestehend aus Aluminium oder einer Aluminium enthaltenden Legierung besteht und/oder eine Wandungsstärke von 50 $\mu$m bis 1 mm, bevorzugt von 100 bis 500 $\mu$m aufweist.

Weiter ist bevorzugt, dass die Innenseite des Reflektors mindestens eine hochreflektive Beschichtung mit einem Reflexionsgrad $p > 70$ % in einem Wellenlängenbereich von 400 bis 800 nm und/oder einem Reflexionsgrad $p > 80$ % in einem Wellenlängenbereich von 900 bis 2500 nm aufweist, insbesondere dass das optisch transparente Fenster ausgewählt ist aus der Gruppe bestehend aus Glas, Plexiglas, Siliciumoxid, Siliciumcarbid und/oder Aluminiumoxid.

Eine weitere bevorzugte Ausführungsform sieht vor, dass der Hohlraum zumindest teilweise mit einem im Wellenlängenbereich von 300 bis 2.500 nm optisch transparenten Material gefüllt ist und/oder dass das optisch transparente Material einen höheren Brechungsindex $n_D^{20}$ als Luft besitzt. Bevorzugt ist das optisch transparente Material ausgewählt aus der Gruppe bestehend aus Epoxidharz, Siliconharz, Polycarbonat, Polyacrylaten, Glas, Quarzglas und/oder thermoplastische Kunststoffen.

Weiter ist bevorzugt, dass die Eintritts- und/oder die Austrittsapertur mit einem im Wellenlängenbereich von 300 bis 2.500 nm optisch transparenten Fenster verschlossen ist, wobei insbesondere das optisch transparente Fenster ausgewählt ist aus der Gruppe bestehend aus Glas, Plexiglas, Siliciumoxid, Siliciumcarbid und/oder Aluminiumoxid.

In einer zusätzlichen vorzugsweisen Ausgestaltung der Sekundäroptik schließt sich an die Auskragung zumindest einseitig ein formschlüssig angeformtes Befestigungselement an, über den die Sekundäroptik mit einem Halbleiterelement und/oder einem Chipträger verbindbar ist. Besonders bevorzugt schließt sich an zumindest zwei gegenüberliegenden Seiten der Auskragung je ein Befestigungselement an. Vorteilhafterweise ist mindestens ein Befestigungselement monolithisch an die Auskragung angeformt.

Spezielle Anwendungsfälle sind die Anwendung in einem Modul zur Stromerzeugung aus Sonnenlicht, bevorzugt einem Modul mit einer zweistufigen Konzentrator-Optik, besonders bevorzugt einem Modul mit einer monolithischen Mehrfachsolarzelle, z.B. einer Dreifachsolarzelle, bevorzugt mit einer Solarzelle aus den Elementen der III. und V. Hauptgruppe des Periodensystems.

Die Funktion der erfindungsgemäßen Sekundäroptik ist es, die an der Eingangsapertur eintreffenden Strahlung auf die an der Ausgangsapertur liegende Solarzelle zu lenken. Zur Erzielung dieser Funktionalität sollte die Sekundäroptik bevorzugt folgende Merkmale und Elemente aufweisen:

- Geeignete Formgebung und Oberflächenausführung zur Maximierung des Wirkungsgrades,
- Elemente zur Erleichterung der Montage in der Serienproduktion,
- Elemente zum Wärmemanagement, d.h. zur Verbesserung der Konvektion und der Wärmestrahlung,
- Elemente, die die Langzeitstabilität erhöhen,
- Elemente, die den Reflektionsgrad erhöhen,
- Elemente, um kritische Bereiche neben der Solarzelle abzuschatten.

An den Herstellungsprozess zur Fertigung dieses Bauteils bestehen folgende Anforderungen:

- Geringe Material- und Prozesskosten,
- Hohe Fertigungsgenauigkeit in Bezug auf Reflektorform,
- Erzeugung von Oberflächen mit geringer Rauheit,
- Minimierung von Grat- und Riefenbildung,
- Aufbringung von möglichst homogenen Schichten zur Reflektionssteigerung mit guten optischen Eigenschaften und hoher Haftkraft,

- Aufbringung von möglichst dichten Schutzschichten mit hoher Transparenz und guter Haftung.

Der Erfindungsgegenstand betrifft dabei nicht nur das eigentliche Reflektorbauteil (Sekundäroptik), sondern das gesamte Halbleiterbauteil oder -baugruppe, das die Sekundäroptik umfasst. Insbesondere ist das Halbleiterbauteil dabei eine sog. Solarzellenbaugruppe, meist SCA genannt (engl. Solar Cell Assembly). Dieses SCA umfasst typischerweise die Solarzelle, den Reflektor, weitere Elemente sowie den Prozess zur Herstellung eines derartigen SCA.

Erfindungsgemäß wird ebenso eine Licht absorbierende Halbleiterbaugruppe, umfassend eine zuvor beschriebene Sekundäroptik sowie ein Licht absorbierendes Halbleiterbauteil, wobei die Sekundäroptik über ihre Austrittsapertur formschlüssig mit dem Licht absorbierenden und/oder Licht emittierenden Halbleiterbauteil verbunden ist, bereitgestellt.

Bevorzugt ist, dass der Verbund durch Verklebung und/oder mechanische Fixierung realisiert wird.

In einer weiter bevorzugten Ausführungsform ist die Sekundäroptik vom Licht absorbierenden und/oder Licht emittierenden Halbleiterbauteil in einem Abstand von 1 bis 5000 $\mu$m, bevorzugt von 5 bis 1000 $\mu$m, besonders bevorzugt zwischen 10 und 300 $\mu$m angeordnet ist, wobei zumindest der zwischen der Sekundäroptik und dem Licht absorbierenden und/oder Licht emittierenden Halbleiterbauteil mit der Verklebung gefüllt. Vorzugsweise ist mindestens eine weiteres Bauteil, ausgewählt aus der Gruppe bestehend aus Kontakten zur elektrischen Verschaltung der Halbleiterbaugruppe mit mindestens einer weiteren Halbleiterbaugruppe, einem Chipträger, einem Verschaltungspad, einem Bonddraht zur elektrischen Verschaltung des Licht absorbierenden und/oder Licht emittierenden Halbleiterbauteils mit dem Verschaltungspad, mindestens eine Schutzdiode und/oder mindestens einer Primäroptik zur Konzentration von Licht auf die Sekundäroptik, wie z.B. ein Fresnel-Kollektor, Linse und/oder Spiegel umfasst, wobei insbesondere das Licht absorbierende und/oder Licht emittierende Halbleiterbauteil und/oder das Verschaltungspad auf dem Chipträger fixiert sind, bevorzugt durch Klebung.

Weiter ist vorteilhaft, wenn die Sekundäroptik über das mindestens eine Befestigungselement mit dem Licht absorbierenden Halbleiterbauteil und/oder dem Chipträger verbunden ist und/oder der Chipträger mindestens eine formschlüssige, reversible Arretierung aufweist, mit der das mindestens eine Befestigungselement verbindbar ist.

Eine typische Solarzellenbaugruppe nach dem Stand der Technik (z.B. US 5,167,724; J. Jaus, U. Fleischfresser, G. Peharz et al., "Heat Sink Substrates for Automated Assembly of Concentrator Modules", Proc. of 21st European Photovoltaic Solar Energy Conference, 2006, pp. 2120-2123; A. W. Bett, C. Baur, F. Dimroth et al., "FLATCON™-modules: Technology and Characterisation", Proc. of 3rd World Conference on Photovoltaic Energy Conversion, 2003, pp. 634-637) besteht aus der Solarzelle, einem Substrat zur Wärmeleitung, z.B. Kupfer, mehreren aufgebrachten Metallschichten zur Verbesserung der Kontaktierbarkeit, einer Lot- oder Kleberschicht zur Kontaktierung der Solarzellenrückseite sowie gebondeten oder geschweißten Kontaktierungen der Solarzellenoberseite. Im Folgenden wird das Substrat zur Wärmeleitung auch häufig als "Chipträger" bezeichnet. Häufig ist dieser Chipträger als Leadframe (Leiterrahmen) ausgeführt.

Durch den Einsatz einer erfindungsgemäßen reflektiven und/oder refraktiven Sekundäroptik wird eine Halbleiterbaugruppe, insbesondere ein Solarzellenmodul vom Bautyp nach A. W. Bett, C. Baur, F. Dimroth et al., "FLATCON™-modules: Technology and Characterisation", Proc. of 3rd World Conference on Photovoltaic Energy Conversion, 2003, pp. 634-637, wesentlich verbessert. Eine derartige Solarzellenbaugruppe mit integrierter Sekundäroptik weist dabei die folgenden Vorteile gegenüber dem Stand der Technik auf:

- Gute Ableitung der von der Solarzelle ausgehenden Wärme,
- Schutz der kritischen Bereiche der Solarzelle (z.B. Ränder der aktiven Schichten, Bondpads) vor Korrosion, thermischer Belastung und/oder Schädigung durch Lichteinstrahlung,
- Resistenz aller verwendeten Elemente gegen die Solarstrahlung, die durch die Fokussierung eine bis zu 10.000-fache Konzentration erreicht.
- Langzeitbeständigkeit des gesamten Aufbaus,
- Verwendungsmöglichkeit kostengünstiger Ausgangsmaterialien,
- Vermeidung und/oder Ausgleich der im Betrieb entstehenden thermischen und/oder mechanischen Spannungen.

Erfindungsgemäß wird weiter ein Verfahren zur Herstellung einer zuvor beschriebenen Halbleiterbaugruppe bereitgestellt, bei der eine im vorangehenden beschriebene Sekundäroptik auf einem Licht absorbierenden Halbleiterbauteil und/oder auf einem Chipträger fixiert wird, bereitgestellt.

Das erfindungsgemäße Verfahren zur Herstellung eines Halbleiterbauteils, insbesondere einer Solarzellenbaugruppe mit reflektiver Sekundäroptik, weist die folgenden Vorteile auf:

- Geringe Material- und Prozesskosten,
- Hohe Positionierungsgenauigkeit der Sekundäroptik relativ zur Solarzelle,
- Vermeidung von Beschädigungen von Solarzelle, Sekundäroptik oder anderen auf der Solarzellenbaugruppe vorhandenen Elementen im Bestückungsvorgang.
- Ausgleich von unvermeidbaren Qualitätsmängeln der verwendeten Bauteile (z.B. Grate an der Reflektorunterseite), dadurch Erhöhung der Gesamtausbeute im Fertigungsprozess.

In einer bevorzugten Ausführungsform des Verfahrens wird die Sekundäroptik zumindest mittels des mindestens einen Befestigungselementes auf dem Chipträger fixiert; insbesondere erfolgt dabei die Fixierung derart, dass das mindestens eine Befestigungselement mit dem Chipträger verklebt, verschraubt, vernietet, verschweißt, verlötet und/oder gebonded wird und/oder über Arretierungsmöglichkeiten, wie z.B. ein ausgeformter Dorn oder eine Kuppe direkt fixiert wird.

Der Erfindungsgegenstand besteht in einer reflektiven oder in einer reflektiven und refraktiven Sekundäroptik sowie in einer Solarzellenbaugruppe mit integrierter reflektiver Sekundäroptik, die durch ihr besonderes Design und ihre speziellen Herstellungsprozesse große Vorteile gegenüber aus dem Stand der Technik bekannten Anordnungen aufweisen.

Zur Montage wird ein zweistufiges Verfahren vorgeschlagen, bei dem die eigentliche Verbindung den Reflektor mechanisch nicht kraftschlüssig an die Zelle, sondern direkt an den Chipträger ankoppelt. Außerdem wird eine Montagemethode vorgeschlagen, bei der ein Sekundärreflektor erfindungsgemäß in eine Ausformung einer zuvor aufgebrachten Umhüllung eingebracht wird.

Die erzeugten Verbesserungen werden im Folgenden im Sinne von vorteilhaften Ausgestaltungen dargestellt, die allesamt fakultativ zu verstehen sind.

Vorteilhafte Ausgestaltungen:

Betreffend die Sekundäroptik:

• Der Reflektor besteht aus Aluminium oder einer Aluminiumlegierung. Besonders geeignet sind hochreines Aluminium (> 99 % Aluminium) sowie Aluminiumlegierungen mit > 99 % Aluminium und Beimengungen < 0.5 % von Magnesium. Weitere vorteilhafte Ausgangsmaterialien sind Edelstahl und Messing.

• Die Reflektoraußenseite ist mit einer Schicht versehen, die ein hohes Abstrahlungsvermögen für Infrarotstrahlung mit Wellenlänge > 4000 nm besitzt.

• Bei Reflektoren aus Aluminium oder einer Aluminiumlegierung besteht diese Schicht vorteilhafterweise aus einer gezielt aufgebrachten Aluminiumoxid-Schicht. Durch diese Schicht kann die Temperatur des Reflektors gesenkt werden, mit allen damit verbunden Vorteilen.

• Die Innenseite des Reflektors ist mit einer hochreflektierenden Silber enthaltenden Schicht sowie mit Schutzschichten versehen, die diese hochreflektive Schicht schützen. Vorteilhaft werden Aluminiumoxid oder Siliziumoxid verwendet.

• Die Innenseite des Reflektors ist mit einer hoch reflektierenden Reinst-Aluminium (> 99 %) enthaltenden Schicht sowie mit Schutzschichten versehen, die diese hochreflektive Schicht schützen. Vorteilhaft werden Aluminiumoxid oder Siliziumoxid verwendet.

Betreffend den Ring des Reflektors (Auskragung):

• Die Baugruppe, bestehend aus Solarzelle, Wärmesenke, Kontaktierungsmaterial, Bonddrähten, Reflektor und gegebenenfalls auch Schutzdiode, Anschlusspad und Dickdrahtbondfuß wird z.B. nach der Montage des Reflektors mit einer Verkapselungsmasse versehen, z.B. einem Epoxy-, Silikon- oder Carbonatkunststoff. Diese Verkapselung schützt die genannten Elemente vor Korrosion.

• Der Reflektor verfügt im oberen Bereich über eine Auskragung, die als Ring ausgebildet ist. Dieser Ring verhindert, dass Strahlung auf die oben genannte Verkapselungsmasse oder die zur Montage des Reflektors verwendeten Klebstoffe fallen kann. Durch die starke Lichtintensität könnte hierdurch die Verkapselungsmasse zerstört werden. Der Erfindungsgegenstand bezieht sich daher auf einen Ring oder eine andere flächige Ausformung, die mindestens so groß ist, dass die darunter befindliche Vergussmasse nicht von der Solarstrahlung getroffen werden kann.

• Dieser Ring ist weiterhin vorteilhaft für die Montage, bei der er als greifbare Fläche für das Pick&Place-Verfahren dient. Hierdurch lässt sich ein Verkratzen der meist empfindlichen Reflektorfläche verhindern. Hierzu ist der Ring in vorteilhafter Weise plan, in vorteilhafter Weise parallel zur Eintrittsapertur ausgeführt. Durch das bevorzugte Verfahren zur Herstellung der Reflektorform, dem Tiefziehen, entsteht dieser Ring ohne weiteren Aufwand und unter minimalem Werkstoffeinsatz.

• Der Ring bzw. eine andere flächige Ausformung am oberen Ende des Reflektors bewirkt eine großflächigere Verteilung der Abwärme im Reflektor. Diese Abwärme entsteht durch eine Absorption der auf den Reflektor treffenden Solarstrahlung bzw. durch die durch Wärmeleitung von der Solarzelle dem Reflektor zugeführte Wärme. Durch die mit dem Ring zur Verfügung gestellte vergrößerte Fläche verbesserte sich der Abtransport der Wärme durch Strahlung bzw. Konvektion der Modul-Innenluft. Die Modul-Innenluft wird wiederum über die Außenwände des Moduls an die Umgebung abgegeben

Betreffend den Herstellungsprozess des Reflektors:

• Verwendung von flachem Bandmaterial der Stärke 50 μm bis 1 mm,

- Ausformung der Reflektorform durch gestuftes Tiefziehverfahren, bei dem mit mehreren Ausstanz- und Umformschritten direkt aus dem flachen Bandmaterial die Reflektorform, der Ring sowie gegebenenfalls besondere Befestigungselemente geformt werden.

- Ein Verfahren, bei dem die einzelnen Reflektorelemente nach den formgebenden Tiefzieh- und Umformprozessen noch nicht vollständig herausgetrennt werden, sondern.noch über stegartige Verbindungselemente im Bandstreifen verbleiben. Die so hergestellten Halbzeuge lassen sich gut weiterer Prozessstufen, wie z.B. einer nasschemischen Nachbehandlung zur Oberflächenbehandlung der Reflektorinnenseite, zuführen. Durch die stegartigen Verbindungselemente verbleiben die einzelnen Reflektoren noch in definierter Form und Lage im Streifenverbund und können so optimal weiterprozessiert werden. Insbesondere wird hierdurch ein Ineinanderrutschen der Einzelbauteile verhindert, wodurch die Innenfläche beschädigt und oberflächentechnische Prozesse erschwert bzw. unmöglich gemacht würden. Außerdem wird durch die bestehende Verbindung zwischen allen Reflektoren im Bandmaterial die elektrische Kontaktierung beim Einsatz von elektrochemischen Prozessschritten in der Nachbehandlung erst ermöglicht.

- Anschließend an den ersten formgebenden Tiefzieh- und Umformungsprozess wird das so hergestellte Bandmaterial mit den ausgeformten Reflektoren optional einer nasschemischen Prozessierung unterzogen. Die Prozessschritte betreffen die Reinigung (z.B. tensidische Reinigung, saure Reinigung, alkalische Reinigung), das chemische oder elektrochemische Glänzen, das chemische oder elektrochemische Entgraten sowie das chemische oder elektrochemische Aufbringen einer Oxidschicht.

- Diese Oxidschicht schützt die reflektive Innenfläche vor den Einflüssen der Umgebungsluft.

- Anschließend erfolgt die Vereinzelung der Reflektoren aus dem Streifen durch einen Stanzprozess.

- Nach der nasschemischen Behandlung der Reflektoren kann zur weiteren Erhöhung des Reflektionsgrades das Aufbringen weiterer Schichten, z.B. silber- oder aluminiumhaltiger Spiegelschichten erfolgen. In diesem Fall werden anschließend noch Schutzschichten, z.B. Aluminiumoxid, Siliciumnitrid oder Siliziumdioxid aufgebracht, z.B. durch Sputtern, chemische Dampfphasenabscheidung (CVD) oder nasschemisch. Zur Verhinderung von freiliegenden Materialübergängen kann vor dem Aufbringen dieser Schutzschichten der Reflektor durch Durchtrennen der Stege aus dem Verbund herausgelöst werden. Die Reflektoren durchlaufen dann in einer geeigneten Magaziniervorrichtung die weiteren Prozesse.

- Durch das Tiefziehverfahren können alle aus der Literatur bekannten optimierten Formen, z.B. konische, parabolische, hyperparabolische oder zusammengesetzt parabolische Formen realisiert werden. Durch die erst nach der Umformung aufgebrachten Schutzschichten wird auf diese kein besonderer Stress mehr ausgeübt und die Umformung ist in kritischen Parametern, wie z.B. dem Aspektverhältnis, nur noch durch das Ziehverhalten des Grundmaterials beeinflusst.

Betreffend die Halbleiterbaugruppe mit Reflektor:

- Bevorzugt ist die Halbleiterbaugruppe ein SCA.

- Die Unterseite der Ausgangsapertur des Reflektors ist durch eine erste Klebstoffschicht mit der Solarzellenoberseite verbunden. Dieser Klebstofffilm besitzt jedoch nur eine sehr geringe Kohäsion und/oder Adhäsion. Auf diese Weise wird bei einer thermisch bedingten Ausdehnung des Reflektors keine Kraft auf die Solarzellenoberseite übertragen (Gefahr der Ablösung der Kontaktmetallisierung der Solarzelle). Diese erste Klebstoffschicht stellt also eine Art Sollbruchstelle dar, die beim ersten Ausdehnen des Reflektors im Betriebsfall zerstört wird.

- Daher wird zusätzlich zu dieser ersten Verbindungsschicht eine zweite Klebstoff- bzw. Vergussmasse aufgetragen, die einen Teil des Chipträger sowie einen Teil des Reflektors einschließt. Diese zweite Klebstoffmasse stellt eine mechanisch belastbare, flächige Verbindung zwischen dem Reflektor und dem Chipträger her. Die Kontaktfläche zur Reflektoraußenwand ist dabei deutlich größer im Vergleich zur Fläche der Unterkante des Reflektors. Dadurch kann diese zweite Klebstoffmasse die bei einer thermischen Ausdehnung auftretenden Kräfte deutlich besser aufnehmen. Außerdem kann die im Reflektor durch Absorption entstehende Wärme besser an den Chipträger abgeführt werden.

- Hierzu kann die zweite Klebstoffmasse durch das Füllen mit thermisch gut leitenden Stoffen, z.B. SiOH-, $SiO_2$ oder $TiO_2$-Partikeln, oder Keramikpartikeln, in ihrer thermischen Leistungsfähigkeit verbessert werden.

- Diese zweite Vergussmasse kann auch den Rand der Solarzelle sowie die Bonddrähte einschließen. Dadurch wird ein Verkapselungseffekt erzielt und somit werden diese besonders kritischen Bereiche vor Witterungseinflüssen geschützt.

- Die für die zweite Vergussmasse verwendeten Materialien, z.B. thermoplastische Kunststoffe, sind meistens nicht dauerhaft beständig gegen stark konzentrierte Strahlung. Daher ist die Auskragung (z.B. ein Ring bzw. eine ähnliche flächige Ausformung) an der Oberseite des Reflektors von essentieller Bedeutung, um im Betrieb diese Vergussmasse vor einer Beschädigung durch auftreffende Strahlung zu schützen. Bei einem Konzentrator-Modul kann z.B.

durch Fehlstellung des Trackers der gesamte Fokus-Strahl auf die Vergussmasse gelenkt werden.

- Alternativ zu diesem Aufbau kann auch der Reflektor über eine Klebeschicht direkt auf die Chipoberfläche, z.B. Oberfläche der Solarzelle, angekoppelt sein. Zur Vermeidung von thermomechanischen Spannungen ist die Klebeschicht aus einem besonders flexiblen Kunststoff ausgeführt und/oder mit Partikeln mit besonders guter Leitfähigkeit, z.B. Silber- oder Kupferpartikeln, gefüllt.

- Als weitere Alternative bietet sich die Verwendung eines Montagebügels an, wie er z.B. aus WO 91/18419 bekannt ist. Aus dieser Anmeldung ist die Verwendung eines Bügels bekannt, die über eine zentrale Aufnahmeöffnung für den eigentlichen Reflektor verfügt. Bevorzugt lässt sich ein derartiger Montagebügel in einem einzigen Verfahrensschritt als monolithischer Verbund mit der Sekundäroptik durch das weiter oben beschriebene kalte Tiefziehverfahren aus einem flachen Metallband direkt aus dem flachen Bandmaterial formen. Diese integrierte Lösung bietet alle Vorteile der Prozessvereinfachung durch den Wegfall von Montageschritten sowie Verringerung des Handlingaufwands durch eine Reduktion der Zahl der benötigten Komponenten. Der Montagebügel übernimmt in diesem Fall die Funktion der abschattenden Auskragung bzw. des Ringes.

- Weiterhin wird ein alternatives Verfahren vorgeschlagen, bei dem der Chipträger über Arretierungsmöglichkeiten (z.B. Laschen) verfügt, die aus der Chipträgerebene herausragen. Die Sekundäroptik verfügt über geeignete Ausformungen, die zur Befestigung auf den Laschen dienen. Die Laschen am Chipträger verfügen über einen Führungsbereich, der zur Aufweitung der entsprechenden Ausformung an der Sekundäroptik dient. Weiterhin verfügen die Arretierungsmöglichkeiten zusätzlich oder alternativ über Überhöhungen (z.B. ausgeformter Dorn oder Kuppe), in die eine entsprechende Aussparung der Ausformung der Sekundäroptik einrasten kann. Die Lasche kann auch an der Sekundäroptik ausgeformt sein, die entsprechende Gegenaufnahme ist dann am Chipträger ausgeformt. Diese Ausgestaltungsform ermöglicht eine zuverlässige, reversible Fixierungsmöglichkeit der Sekundäroptik im gesamten Verbund des Halbleiterbauteils, bei der auf Klebungen weitestgehend verzichtet werden kann.

- Die Solarzelle verfügt auf ihrer Oberseite im Bereich der Auflagefläche des Reflektors über eine geeignete Schicht, um beim Montageprozess eine Beschädigung der Metallisierung oder der darunter liegenden Halbleiterschichten zu verhindern. Diese Schicht kann z.B. als Oxidschicht, Metallschicht oder als Kunststoffschicht, wie Polyimid oder PTFE ausgeführt sein.

- Die Sekundäroptik kann auch zur elektrischen Anbindung der Solarzellenoberseite verwendet werden. Hierzu verfügt der Reflektor über eine vergrößerte Ausformung an der Oberseite, die neben der Solarzelle auf einen zweiten elektrischen Leiterbereich elektrisch leitfähig verbunden wird, wobei der zweite elektrische Leiterbereich vom Chipträger, der den ersten Bereich bildet, elektrisch isoliert ist.

Betreffend das Montageverfahren der Solarzellenbaugruppe:

- Es existieren mehrere vorteilhafte Montageverfahren. Beim erfindungsgemäßen Standard-Montageverfahren wird zunächst eine erste adhäsive Masse mit geringer Viskosität und mit geringer Kohäsion und/oder geringer Adhäsion und/oder sehr hoher Elastizität durch Dispensen, Ink-Jet-Verfahren, Stempeln o.ä. aufgetragen. Anschließend wird die Sekundäroptik mittels eines Greifers, z.B. Vakuumgreifer, aus einer geeigneten Magaziniervorrichtung entnommen und durch ein Vision-System von der Unterseite her vermessen. Unter Berücksichtigung der Korrektur-Information vom Vision-System wird die Sekundäroptik auf die zuvor aufgetragenen erste adhäsive Masse aufgesetzt. Hierzu wird über eine Federspannung eine maximale Aufsetzkraft definiert oder über im Montagekopf eingebaute Abstandshalter oder einen Höhensensor ein definierter Abstand von 10 bis 200 $\mu$m zum Chip eingehalten. Alternativ hierzu kann der Auftrag auch auf den Reflektor erfolgen. Wenn notwendig, kann anschließend diese erste adhäsive Masse vor den weiteren Prozessschritten ausgehärtet werden, bei besonders niedrig viskosen adhäsiven Massen ist dies nicht notwendig. Anschließend wird die so fixierte Sekundäroptik mit einer zweiten adhäsiven Masse teilweise umhüllt. Die erste adhäsive Masse verhindert dabei, dass die zweite adhäsive Masse durch Kapillareffekte auf den aktiven Solarzellenbereich gelangen kann. Abschließend wird die zweite Masse ausgehärtet.

- Ein weiteres vorteilhaftes Montageverfahren hat folgenden Ablauf: Die Baugruppe umfassend Solarzelle, Wärmesenke, Unterseiten- und Oberseitenkontaktierung der Solarzelle sowie evtl. auch der Schutzdiode mit Kontaktierungen sowie evtl. Kontaktpads mit Kontaktierungen, wird mit einer Vergussmasse vergossen. Der Verguss erfolgt dergestalt, dass Teile der Baugruppe oder auch die gesamte Baugruppe in die Vergussmasse eingeschlossen werden. Der vergossene Bereich weist im Bereich der Solarzelle eine Ausnehmung auf, die an die Außenform der Sekundäroptik angepasst ist. In diese Ausnehmung lässt sich der Reflektor einsetzen und durch Reibung oder zusätzlich hinzugefügte Adhäsive dauerhaft fixieren. Diese Ausführungsform weist die Vorteile auf, dass die Solarzelle durch die Verkapselung vor Umwelteinflüssen geschützt werden kann, dass bei einer Wärmeausdehnung des Reflektors die entstehenden Kräfte großflächig in die Vergussmasse eingeleitet werden, sowie dass die durch die absorbierte Strahlung entstehende Wärme über einen großflächigen Kontakt mit der Vergussmasse gut abgeführt werden kann.

- Eine weitere vorteilhafte Ausgestaltung ist die Montage eines Reflektors mittels eines im Voranstehenden beschriebenen Montagebügels. Ebenso bevorzugt ist die Verwendung eines mit Partikeln aus Siliziumoxid, Siliziumhydroxid, Silber o.ä. gut leitenden Materialien enthaltenden Klebstoffes für die Montage des Bügels oder eine Montage mittels direkten Fügens (Schweißen, Löten, Bonden).

- Der Reflektor weist bevorzugt einen Abstand zur Solarzelle auf, der gemessen von der Unterseitenapertur des Reflektors bis zum Oberseitengrid der Solarzelle in Höhe, 20 bis 300 $\mu$m beträgt.

- Der Reflektor kann als reflektives Element ausgebildet sein, das aus einem optisch transparenten Bereich mit einem höheren Brechungsindex als Luft, z.B. einem Epoxy-, Silikon- oder Carbonatkunststoff, sowie einer den Seitenbereich umgebenden reflektiven Schicht besteht. Hierdurch ergeben sich zwei wesentliche Vorteile: Erstens ergibt sich durch den höheren Brechungsindex (gegenüber Luft) des optisch transparenten Bereichs eine zusätzliche Ablenkung der von der Primärlinse schräg auf die Oberfläche des transparenten Bereichs eintreffenden Strahlen in Richtung der Solarzelle, zweitens wird die Solarzellenoberfläche durch den transparenten Bereich vor Umwelteinflüssen abgeschirmt. Die Sekundäroptik weist dann zusätzlich zu den reflektiven auch refraktive Eigenschaften auf, die sich auf vorteilhafte Weise ergänzen.

- Ein derartiges Bauelement lässt sich z.B. durch Befüllung eines tiefgezogenen Reflektors mit einer transparenten Masse, z.B. einem Epoxy-, Silikon- oder Carbonatkunststoff, realisieren.

- Eine vorteilhafte Ausgestaltung ist die Verwendung von transparenten Massen mit hohem Benetzungswinkel (> 90°) auf Aluminiumoxid. In diesem Fall wird bevorzugt eine konvex-linsenförmige Oberfläche erzeugt, die durch Temperatureffekte im Betrieb noch verstärkt wird. Durch die konvexe Oberfläche werden Randstrahlen vorteilhaft gebrochen und die Zahl der Reflektionen und damit die Verluste minimiert. Die konvexe Ausformung der Oberfläche ist daher vorteilhaft für die Winkelakzeptanz des Konzentrator-Moduls sowie für weitere optische Parameter (Verkippungstoleranz, Konzentrationserhöhung).

- Die Befüllung des Reflektors mit der optisch transparenten Masse kann vor, während oder nach der Montage auf die Solarzelle erfolgen. Eine vorteilhafte Ausführungsform ist die Befüllung des Reflektors vor der Aufbringung auf die Solarzelle. Hierzu wird der Innenraum oder ein Teil des Innenraums des Reflektors ungefähr bis zur Austrittsapertur mit der transparenten Masse gefüllt und diese ausgehärtet. Die Ebene der Austrittsapertur wird von dem transparenten Bereich vorteilhafterweise um 20 bis 300 $\mu$m überragt. Hierdurch ergibt sich eine Fläche in der Größe der Ausgangsapertur bzw. des aktiven Bereichs der Solarzelle. Diese Fläche dient zur Montage der Sekundäroptik direkt auf der Solarzelle mittels einer optisch transparenten adhäsiven Masse.

- Eine weitere vorteilhafte Montagemethode ist es, auf die Solarzellebaugruppe vor Montage im Bereich der Solarzelle eine dünnflüssige optisch transparente Masse aufzutragen. In diese Masse wird dann die reflektive Sekundäroptik hineingesetzt und durch Aushärten der Masse fixiert. Der im Inneren der Sekundäroptik befindliche Teil der Vergussmasse dient dabei als Schutzschicht für die aktive Fläche der Solarzelle sowie gleichzeitig durch seine im Vergleich zu Luft höheren Dichte als optische Strahllenkung. Zur Verstärkung dieses Effektes kann durch weiteres Zugießen von transparenter Vergussmasse in den Reflektor eine Verstärkung dieses Effekts erzielt werden. Gleichzeitig dient der außerhalb des Reflektors aushärtende Teil der Vergussmasse als Schutz der Zellränder und der Verbindungen zur Oberflächenkontaktierung (Bonddrähte) vor Witterungseinflüssen.

Der Gegenstand der vorliegenden Erfindung wird anhand der Figuren näher erläutert, ohne diesen auf die in den Figuren speziell dargestellten Parameter zu beschränken.

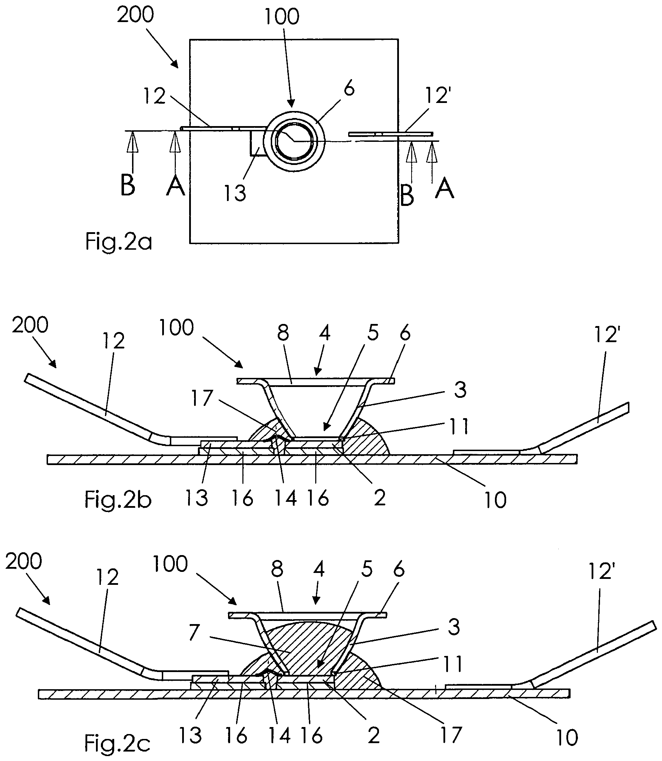

Die Figur 2a zeigt eine spezielle Ausgestaltungsform einer SCA, die eine erfindungsgemäße Sekundäroptik umfasst, in Aufsicht, während die Figuren 2b und 2c Schnitte entlang den in Figur 2a angedeuteten Verbindungslinien A-A bzw. B-B darstellen. Die Figuren 2a, 2b und 2c betreffen dabei eine besondere Ausführungsform, bei der die Sekundäroptik 100 in das Halbleiterbauteil 200, das im vorliegenden Fall eine SCA darstellt, integriert ist, wobei mehrere Klebeverbindungen zur Fixierung des Halbleiterbauteils vorgesehen sind. Alle Bestandteile der SCA 200 sind dabei auf dem Chipträger 10 aufgebracht. Die Solarzelle 2 sowie das Verschaltungspad 13, über die der von der SCA 200 produzierte Strom über die Kontakte zur Verschaltung 12 und 12' abgegriffen werden kann, sind dabei jeweils durch eine Klebung oder Lötung 16 mit dem Chipträger 10 verbunden. Die Stromleitung von der Solarzelle 2 selbst zum Verschaltungspad 13 erfolgt dabei über einen Bonddraht 14. Die erfindungsgemäße Sekundäroptik 100 selbst besteht dabei aus dem als Reflektor 3 ausgebildeten Gehäuse, das im Wesentlichen aus einem metallischen Grundmaterial, das an der Innenseite eine besonders hohe Reflektion für Licht im Wellenlängenbereich von 350 bis 2000 nm aufweist, ausgebildet ist. An der Oberfläche ist eine monolithisch ausgeformte Auskragung 6 ausgebildet, die einerseits als Montagehilfe dienen kann, andererseits gleichzeitig kritische Bereiche der Solarzellenbaugruppe vor dem konzentrierten Sonnenlicht schützt. Dies wird v.a. aus der in Figur 2a dargestellten Aufsicht ersichtlich. Außerdem weist der Reflektor 3 an seiner Außenseite eine Schicht auf, die eine besonders günstige Emissivität im Wellenlängenbereich von 2000 bis 10000 nm aufweist, z.B. eine Schicht aus Aluminiumoxid. Der Chipträger 10 übernimmt dabei die Funktion eines Kühlsubstrates, wobei durch die großflächige Ausbildung des Chipträgers effektiv Wärme abgeleitet werden kann. Eine vorteilhafte Anordnung sieht vor, dass die optische Achse der Sekundäroptik 100 möglichst durch den geometrischen Schwerpunkt der aktiven Fläche der Solarzellenanordnung 200 verläuft. Die Eintrittsapertur 4 der Sekundäroptik 10 ist dabei von einem im interessierenden Wellenlängenbereich transparenten Fenster 8 verschlossen. Die Fixierung der Sekundäroptik 100 mit der Solarzelle 2 erfolgt dabei im Bereich der Austrittsapertur 5 durch eine erste Verklebung 11. Die weitere Verfestigung der Sekundäroptik 100 auf der SCA 200 wird durch eine zusätzliche Verbundmasse 17, die um die Sekundäroptik aufgebracht wird, gewährleistet. Dabei kann die Verbundmasse 17 einige Bestandteile der SCA 200, wie beispielsweise die Solarzelle, das Verschaltungspad 13 und den Bonddraht 14 einschließen. Durch die Auskragung 6 ist gewährleistet, dass zumindest die Verbundmasse sowie die darunter liegenden Teile der SCA 200 von der aggressiven, konzentrierten Sonneneinstrahlung geschützt werden. Dadurch ist sichergestellt, dass das Verbundmaterial 17 effizient vor Alterungsprozessen, wie beispielsweise Versprödung, geschützt ist.

In Figur 2c ist eine alternative Ausführungsform der in den Figuren 2a und 2b dargestellten SCA 200 mit Sekundäroptik 100, dargestellt, wobei hier der Innenraum der Sekundäroptik 100 mit einem optisch transparenten Füllmaterial 7 nahezu gänzlich gefüllt ist. Im Falle, dass dieses Füllmaterial 7 einen hohen Brechungsindex aufweist, erfolgt zusätzlich oder alternativ zur reflektiven Konzentration des Sonnenlichtes innerhalb der Sekundäroptik 100 auch eine refraktive Konzentration. Die Oberfläche des Füllmaterials ist dabei vorzugsweise konvex ausgebildet.

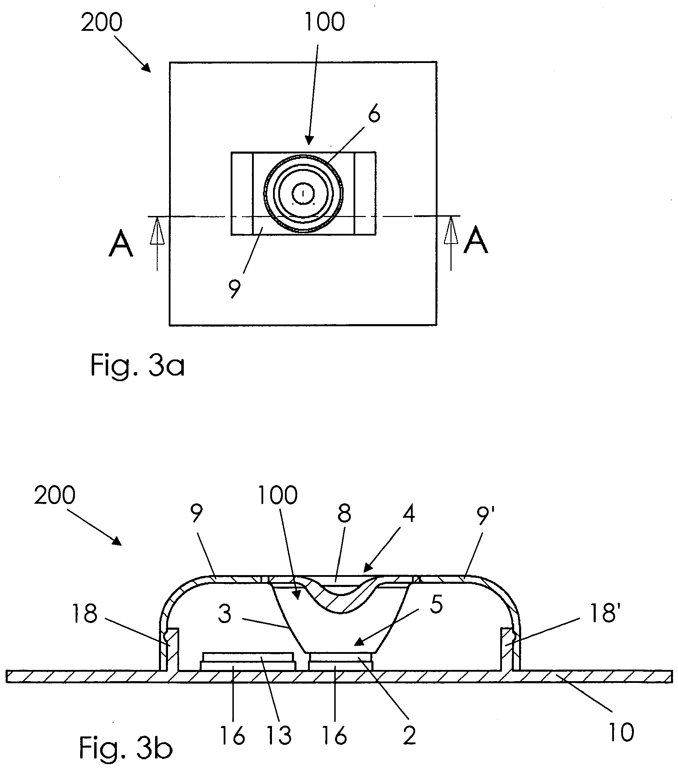

Die Figuren 3a und 3b betreffen eine weitere, vorteilhafte Ausführungsform einer Anordnung 200 mit Sekundäroptik 100, wobei hier nur der Übersichtlichkeit halber einige Bestandteile der SCA 200 (beispielsweise Bonddraht 14) nicht aufgeführt sind. Im Wesentlichen betreffen die Ausführungsformen der Figuren 3a und 3b, wobei Figur 3a eine perspektivische Betrachtungsweise der SCA 200 darstellt, während Figur 3b einen Schnitt entlang der Linie A-A der Figur 3a darstellt, eine alternative Fixierungsmöglichkeit der Sekundäroptik 100 auf dem Chipträger 10. Hierbei weist der Chipträger 10 die Arretierungsmöglichkeiten 18 bzw. 18' auf, die jeweils eine Nut aufweisen, die der Fixierung der mechanischen Befestigungselemente 9 und 9', die jeweils als Bügel ausgeprägt sind, dient. Die Befestigungselemente 9 und 9' sind dabei formschlüssig mit der Sekundäroptik 100 verbunden und übernehmen die Funktion der Auskragung 6. Alternativ hierzu ist es aber auch besonders bevorzugt, wenn die Befestigungselemente 9, 9' monolithisch mit dem Reflektor 3 verbunden sind; dies ist beispielsweise bei einer Herstellung der Sekundäroptik 100 durch ein Tiefziehverfahren möglich. Der besondere Vorteil einer derartigen Ausführungsform ist, dass durch einfache mechanische Mittel eine permanente Fixierung der Sekundäroptik 100 auf der Solarzelle 2 unter Verzicht einer Verklebung hergestellt werden kann. Durch die große Fläche der Bügel 9 und 9', die vorzugsweise aus Metall gebildet sind, ist eine gänzliche Abschirmung der darunter liegenden Bauteile, wie beispielsweise dem Verschaltungspad 13, gewährleistet. Ebenso ist eine gute Ableitung von thermischer Energie über die Bügel 9 und 9' auf den Chipträger 10 ermöglicht.

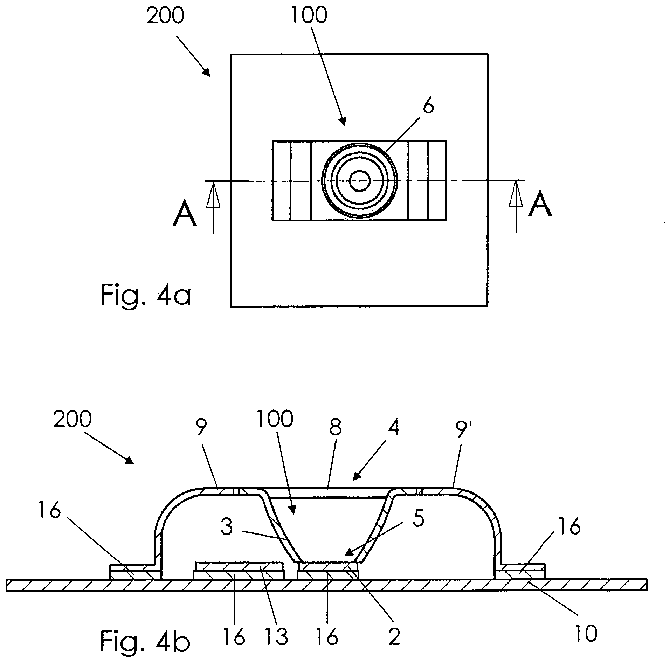

Eine weitere alternative Ausführungsform der mechanischen Fixierung der Sekundäroptik 100 auf dem Chipträger 10 ist in den Figuren 4a und 4b dargestellt, wobei, wie bereits bei den vorangehenden Figuren, die Figur 4b einen Schnitt entlang den Linien A-A der Figur 4a darstellt. Die mechanische Fixierung der Bügelelemente 9 und 9' erfolgt hierbei durch Verklebung 16 mit dem Chipträger 10. Die weiteren Ausführungsformen sind identisch mit den Merkmalen der Figuren 3a und 3b.

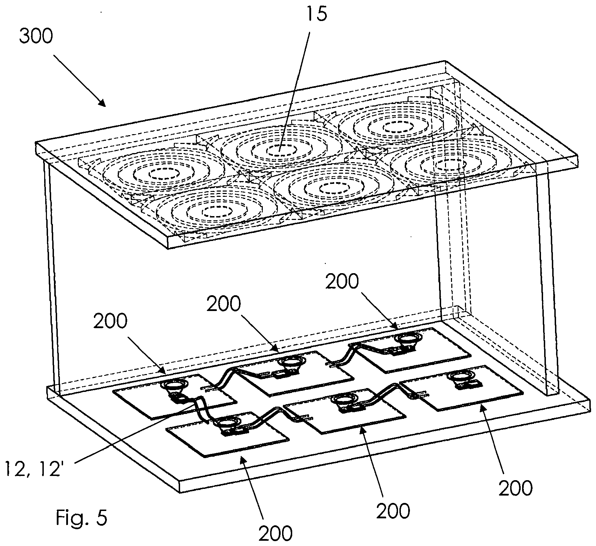

In Figur 5 ist ein Modul 300 dargestellt, das mehrere, über die Kontakte 12 und 12' verschaltete SCAs 200 beinhaltet. Ebenso gezeigt ist die Anordnung der konzentrierenden Primäroptik 15, die in diesem Falle als Fresnel-Kollektor ausgebildet ist.

**Patentansprüche**

1. Reflektive oder reflektive und refraktive Sekundäroptik (100) zur Fokussierung von Sonnenlicht auf Licht absorbierende Halbleiterbauteile, umfassend einen Reflektor (3) mit einer dem Sonnenlicht zugewandten Eintrittsapertur (4) und einer dem Halbleiterbauteil (2) zugewandten Austrittsapertur (5), **dadurch gekennzeichnet, dass** die Innenseite des Reflektors (3) mindestens eine aufgebrachte Schutzbeschichtung aufweist, die Aluminiumoxid, Siliciumnitrid und/oder Siliciumoxid enthält oder hieraus besteht, und dass der Reflektor (3) eine den Reflektor (3) umschließende Auskragung (6) aufweist.

2. Sekundäroptik nach Anspruch 1,
**dadurch gekennzeichnet, dass** die Außenseite des Reflektors (3) und/oder die der Austrittsapertur (5) zugewandte Oberfläche der Auskragung (6) mindestens eine Beschichtung aufweist, die einen Gesamtemissionsgrad $\varepsilon_n$ zwischen 0,5 und 0,95 im Wellenlängenbereich von 2.000 bis 10.000 nm aufweist, wobei die mindestens eine Beschichtung bevorzugt Aluminiumoxid enthält, bevorzugt aus Aluminiumoxid besteht und/oder bevorzugt einen Lack

mit einem Gesamtemissionsgrad $\varepsilon_n$ zwischen 0,5 und 0,95 enthält, bevorzugt hieraus besteht.

3. Sekundäroptik nach einem der vorhergehenden Ansprüche, wobei

a) die Innenseite des Reflektors (3) mindestens eine hochreflektive Beschichtung mit einem Reflexionsgrad p > 70 % in einem Wellenlängenbereich von 400 bis 800 nm und/oder einem Reflexionsgrad p > 80 % in einem Wellenlängenbereich von 900 bis 2500 nm und/oder aufweist,
b) die hochreflektive Beschichtung ein Metall, ausgewählt aus der Gruppe bestehend aus Aluminium, bevorzugt in hochreiner (> 99 Gew.-%) Form; Silber, Schichtfolge von Materialien mit unterschiedlichen Brechungsindices $n_D^{20}$ und/oder Legierungen oder Kombinationen hieraus enthält oder hieraus besteht,

**dadurch gekennzeichnet, dass** auf der Innenseite des Reflektors (3) mindestens eine hochreflektive Beschichtung und auf der mindestens einen hochreflektiven Beschichtung mindestens eine Schutzbeschichtung aufgebracht ist.

4. Sekundäroptik nach einem der vorhergehenden Ansprüche, wobei

a) der Hohlraum zumindest teilweise mit einem im Wellenlängenbereich von 300 bis 2.500 nm optisch transparenten Material (7) gefüllt ist und/oder
b) das optisch transparente Material (7) einen höheren Brechungsindex $n_D^{20}$ als Luft besitzt,

**dadurch gekennzeichnet, dass** das optisch transparente Material (7) in flüssigem Aggregatszustand einen Benetzungswinkel von mehr als 90° auf Aluminiumoxid aufweist.

5. Licht absorbierende Halbleiterbaugruppe, umfassend eine Sekundäroptik nach einem der Ansprüche 1 bis 4 sowie ein Licht absorbierendes Halbleiterbauteil (2),
**dadurch gekennzeichnet, dass** die Sekundäroptik (100) über ihre Austrittsapertur (5) formschlüssig mit dem Licht absorbierenden Halbleiterbauteil (2) verbunden ist.

6. Halbleiterbaugruppe nach vorhergehendem Anspruch,
**dadurch gekennzeichnet, dass** der Verbund durch Verklebung (11) und/oder mechanische Fixierung (9) realisiert wird.

7. Halbleiterbaugruppe nach einem der beiden vorhergehenden Ansprüche,
**dadurch gekennzeichnet, dass** das Licht absorbierende Halbleiterbauteil (2) und die Sekundäroptik (100) mit einer Verbundmasse (17) auf dem Chipträger (10) fixiert sind, wobei die Verbundmasse (17) zumindest das Licht absorbierende Halbleiterbauteil (2) und die Sekundäroptik (100) zumindest teilweise einschließt, wobei die Verbundmasse (17) vorzugsweise ausgewählt ist aus der Gruppe bestehend aus thermoplastischen Kunststoffen, Epoxidharzen, Siliconen, Acrylaten und/oder Cyanacrylaten.

8. Halbleiterbaugruppe nach vorhergehendem Anspruch,
**dadurch gekennzeichnet, dass** die Verbundmasse (17) Silberpartikel, Kupferpartikel und/oder Keramikpartikel, Kieselgel und/oder Kombinationen hieraus enthält.

9. Halbleiterbaugruppe nach einem der Ansprüche 7 oder 8,
**dadurch gekennzeichnet, dass** in Projektionsrichtung auf den Chipträger (10) die Verbundmasse (17) vollständig von der Auskragung (6) der Sekundäroptik (100) verdeckt ist.

10. Halbleiterbaugruppe nach einem der Ansprüche 5 bis 9,
**dadurch gekennzeichnet, dass**

a) das mindestens eine Licht absorbierende Halbleiterbauteil (2) zumindest auf der mit der Sekundäroptik (100) verbundenen Seite zumindest eine Schutzbeschichtung, vorzugsweise ausgewählt aus der Gruppe bestehend aus einer Metall- schicht; Oxidschicht, insbesondere Aluminium- oxid und/oder Kunststoffschicht, wie z.B. Polyimid und/oder PTFE, aufweist,
b) die Sekundäroptik (100) elektrisch mit dem mindestens einen Licht absorbierenden Halbleiterbau- teil (2) kontaktiert ist und/oder
c) die Halbleiterbaugruppe mit mindestens einer weiteren Halbleiterbaugruppe über den mindestens einen Kontakt elektrisch seriell und/oder parallel verschaltet ist.

11. Verfahren zur Herstellung einer Halbleiterbaugruppe nach einem der Ansprüche 5 bis 10,
**dadurch gekennzeichnet, dass** eine Sekundäroptik nach einem der Ansprüche 1 bis 4 auf einem Licht absorbierenden Halbleiterbauteil (2) und/oder auf einem Chipträger (10) fixiert wird.

12. Verfahren nach vorhergehendem Anspruch, umfassend die folgenden Schritte:

a) Auftragen einer Verklebung (11) auf dem Licht absorbierenden Halbleiterbauteil (2)
b) Aufdrücken der Sekundäroptik (100) auf dem Licht absorbierenden Halbleiterbauteil (2), so dass ein Abstand zwischen von 1 bis 5000 µm, bevorzugt von 5 bis 1000 µm, besonders bevorzugt von 10 bis 300 µm zwischen Sekundäroptik (100) und dem Licht absorbierenden Halbleiterbauteil (2) eingehalten wird,
c) Umhüllen des im Schritt a) und b) hergestellten Verbundes mit einer Verbundmasse (17), die im Anschluss ausgehärtet wird,

wobei das Auftragen der Verklebung (11) bevorzugt mittels Ink-Jet-Verfahren und/oder Stempelprozessen erfolgt.

13. Verfahren nach Anspruch 11,
**dadurch gekennzeichnet**, umfassend die folgenden Schritte:

a) Auftragen einer Verbundmasse (17) um das Licht absorbierende Halbleiterbauteil (2) unter Freilassung einer Ausnehmung,
b) Einsetzen und Fixieren der Sekundäroptik (100) in die Ausnehmung,

wobei bevorzugt die Vergussmasse auf den Chipträger (10), auf dem das Licht absorbierende Halbleiterbauteil (2) angeordnet ist, aufgetragen wird und weiter bevorzugt weiterhin der Bonddraht (14), das Verschaltungspad (13) und/oder die mindestens eine Schutzdiode zumindest teilweise von der Vergussmasse eingeschlossen werden.

14. Verfahren nach Anspruch 13,
**dadurch gekennzeichnet, dass** das Fixieren der Sekundäroptik (100) durch Haftreibung und/oder Zugabe weiterer Adhäsive auf die Kontaktflächen zwischen der Sekundäroptik (100) und der Ausnehmung der Vergussmasse erfolgt.

15. Verfahren nach Anspruch 11,
**dadurch gekennzeichnet, dass** auf das Licht absorbierende Halbleiterbauteil (2) eine Verklebung (11) aufgetragen wird, die Sekundäroptik (100) auf die mit der Verklebung (11) beschichtete Stelle des Licht absorbierenden Halbleiterbauteils (2) aufgedrückt wird und im Anschluss das Adhäsionsmittel ausgehärtet wird.

**Claims**

1. Reflective or reflective and refractive secondary optical unit (100) for focusing sunlight onto light-absorbing semiconductor components, comprising a reflector (3) having an entrance aperture (4) facing the sunlight and an exit aperture (5) facing the semiconductor component (2), **characterized in that** the inner side of the reflector (3) has at least one applied protective coating which contains or consists of aluminium oxide, silicon nitride and/or silicon oxide, and **in that** the reflector (3) has a projection (6) enclosing the reflector (3).

2. Secondary optical unit according to Claim 1, **characterized in that** the outer side of the reflector (3) and/or that surface of the projection (6) which faces the exit aperture (5) have/has at least one coating having a total emissivity $\varepsilon_n$ of between 0.5 and 0.95 in the wavelength range of 2,000 to 10,000 nm, wherein the at least one coating preferably contains aluminium oxide, preferably consists of aluminium oxide and/or preferably contains a lacquer having a total emissivity $\varepsilon_n$ of between 0.5 and 0.95, preferably consists thereof.

3. Secondary optical unit according to either of the preceding claims,
wherein

a) the inner side of the reflector (3) has at least one highly reflective coating having a reflectance $\rho > 70\%$ in a wavelength range of 400 to 800 nm and/or a reflectance $\rho > 80\%$ in a wavelength range of 900 to 2500 nm and/or
b) the highly reflective coating contains or consists of a metal, selected from the group consisting of aluminium, preferably in highly pure (> 99% by weight) form; silver, layer sequence of materials having different refractive indices $n_D^{20}$ and/or alloys or combinations thereof,

**characterized in that** at least one highly reflective coating is applied on the inner side of the reflector (3) and at least one protective coating is applied on the at least one highly reflective coating.

4. Secondary optical unit according to any of the preceding claims, wherein

a) the cavity is at least partly filled with a material (7) which is optically transparent in the wavelength range of 300 to 2,500 nm, and/or
b) the optically transparent material (7) has a higher refractive index $n_D^{20}$ than air,

**characterized in that** the optically transparent material (7) in the liquid state of matter has a wetting angle of more than 90° on aluminium oxide.

5. Light-absorbing semiconductor assembly, comprising a secondary optical unit according to any of Claims 1 to 4 and a light-absorbing semiconductor component (2),

**characterized in that** the secondary optical unit (100) is bonded via its exit aperture (5) to the light-absorbing semiconductor component (2) in a positively locking manner.

6. Semiconductor assembly according to the preceding claim, **characterized in that** the bond is realised by adhesive bond (11) and/or mechanical fixing (9).

7. Semiconductor assembly according to either of the two preceding claims, **characterized in that** the light-absorbing semiconductor component (2) and the secondary optical unit (100) are fixed on the chip carrier (10) by a bond compound (17), wherein the bond compound (17) at least partly encloses at least the light-absorbing semiconductor component (2) and the secondary optical unit (100), wherein the bond compound (17) is preferably selected from the group consisting of thermoplastics, epoxy resins, silicones, acrylates and/or cyanoacrylates.

8. Semiconductor assembly according to the preceding claim, **characterized in that** the bond compound (17) contains silver particles, copper particles and/or ceramic particles, silica gel and/or combinations thereof.

9. Semiconductor assembly according to either of Claims 7 and 8, **characterized in that** in the projection direction of the chip carrier (10) the bond compound (17) is completely covered by the projection (6) of the secondary optical unit (100).

10. Semiconductor assembly according to any of Claims 5 to 9, **characterized in that**

   a) the at least one light-absorbing semiconductor component (2) has, at least on the side bonded to the secondary optical unit (100), at least one protective coating, preferably selected from the group consisting of a metal layer; oxide layer, in particular aluminium oxide, and/or plastics layer, such as e.g. polyimide and/or PTFE,
   b) the secondary optical unit (100) is electrically contacted with the at least one light-absorbing semiconductor component (2) and/or
   c) the semiconductor assembly is interconnected electrically in series and/or in parallel with at least one further semiconductor assembly via the at least one contact.

11. Method for producing a semiconductor assembly according to any of Claims 5 to 10, **characterized in that** a secondary optical unit according to any of Claims 1 to 4 is fixed on a light-absorbing semiconductor component (2) and/or on a chip carrier (10).

12. Method according to the preceding claim, comprising the following steps:

   a) applying an adhesive bond (11) on the light-absorbing semiconductor component (2),
   b) pressing the secondary optical unit (100) on the light-absorbing semiconductor component (2), such that a distance of from 1 to 5,000 $\mu$m, preferably from 5 to 1,000 $\mu$m, particularly preferably from 10 to 300 $\mu$m, is maintained between the secondary optical unit (100) and the light-absorbing semiconductor component (2),
   c) enveloping the composite produced in steps a) and b) with a bond compound (17), which is subsequently cured,

wherein applying the adhesive bond (11) is preferably carried out by means of inkjet methods and/or stamping processes.

13. Method according to Claim 11, comprising the following steps:

   a) applying a bond compound (17) around the light-absorbing semiconductor component (2) whilst leaving free a cutout,
   b) inserting and fixing the secondary optical unit (100) into the cutout, wherein preferably the potting compound is applied on the chip carrier (10), on which the light-absorbing semiconductor component (2) is arranged, and with further preference furthermore the bonding wire (14), the interconnection pad (13) and/or the at least one protective diode are/is at least partly enclosed by the potting compound.

14. Method according to Claim 13, **characterized in that** fixing the secondary optical unit (100) is carried out by static friction and/or addition of further adhesives to the contact areas between the secondary optical unit (100) and the cutout of the potting compound.

15. Method according to Claim 11, **characterized in that** an adhesive bond (11) is applied on the light-absorbing semiconductor component (2), the secondary optical unit (100) is pressed onto that location of the light-absorbing semiconductor component (2) which is coated with the adhesive bond (11), and the adhesion medium is subsequently cured.

**Revendications**

1. Optique secondaire réflexive ou réflexive et réfringente (100) pour la focalisation de la lumière du soleil sur des composants semi-conducteurs absorbant la lumière, comprenant un réflecteur (3) avec une ouverture d'entrée (4) orientée vers la lumière du soleil et une ouverture de sortie (5) orientée vers le composant semi-conducteur (2), **caractérisée en ce que** l'intérieur du réflecteur (3) comprend au moins un revêtement de protection qui contient de l'oxyde d'aluminium, du nitrure de silicium et/ou de l'oxyde de silicium ou qui est constitué de ceux-ci et **en ce que** le réflecteur (3) comprend une saillie (6) entourant le réflecteur (3).

2. Optique secondaire selon la revendication 1, **caractérisée en ce que** l'extérieur du réflecteur (3) et/ou la surface de la saillie (6) orientée vers l'ouverture de sortie (5) comprend au moins un revêtement qui présente une émissivité totale $\varepsilon_n$ entre 0,5 et 0,95 dans la plage de longueurs d'onde de 2 000 à 10 000 nm, l'au moins un revêtement contenant de préférence de l'oxyde d'aluminium, de préférence étant constitué d'oxyde d'aluminium et/ou de préférence contenant une peinture avec une émissivité totale $\varepsilon_n$ entre 0,5 et 0,95, de préférence est constitué de ceux-ci.

3. Optique secondaire selon l'une des revendications précédentes,

   a) l'intérieur du réflecteur (3) comprenant au moins un revêtement hautement réfléchissant avec une réflexivité p > 70 % dans une plage de longueurs d'onde de 400 à 800 nm et/ou une réflexivité p > 80 % dans une plage de longueurs d'onde de 900 à 2 500 nm et/ou
   b) le revêtement hautement réfléchissant contenant ou étant constitué d'un métal sélectionné dans le groupe constitué de l'aluminium, de préférence sous forme hautement pure (> 99 % en poids) ; de l'argent, une série de couches de matériaux avec différents indices de réfraction $n^{20}_D$ et/ou des alliages ou combinaisons de ceux-ci,

   **caractérisée en ce que**, sur l'intérieur du réflecteur (3) est appliqué au moins un revêtement hautement réfléchissant et sur l'au moins un revêtement hautement réfléchissant est appliqué au moins un revêtement de protection.

4. Optique secondaire selon l'une des revendications précédentes,

   a) l'espace creux étant rempli au moins partiellement avec un matériau optiquement transparent (7) dans la plage de longueurs d'onde de 300 à 2 500 nm et/ou
   b) le matériau optiquement transparent (7) présentant un indice de réfraction $n^{20}_D$ supérieur à celui de l'air,

   **caractérisé en ce que** le matériau optiquement transparent (7) présente, dans l'état d'agrégat fluide, un angle de mouillage supérieur à 90° sur l'oxyde d'aluminium.

5. Sous-ensemble semi-conducteur absorbant la lumière, comprenant une optique secondaire selon l'une des revendications 1 à 4 ainsi qu'un composant semi-conducteur absorbant la lumière (2), **caractérisé en ce que** l'optique secondaire (100) est reliée, par l'intermédiaire de son ouverture de sortie (5), par complémentarité de forme, avec le composant semi-conducteur absorbant la lumière (2).

6. Sous-ensemble semi-conducteur selon la revendication précédente, **caractérisé en ce que** le composite est réalisé par collage (11) et/ou fixation mécanique (9).

7. Sous-ensemble semi-conducteur selon l'une des deux revendications précédentes, **caractérisé en ce que** le composant semi-conducteur absorbant la lumière (2) et l'optique secondaire (100) sont fixés par une masse composite (17) sur le support de puce (10), la masse composite (17) englobant au moins le composant semi-conducteur absorbant la lumière (2) et l'optique secondaire (100) de manière au moins partielle, la masse composite (17) étant de préférence sélectionnée dans le groupe constitué de matières plastiques thermoplastiques, de résines époxy, de silicones, d'acrylates et/ou de cyanoacrylates.

8. Sous-ensemble semi-conducteur selon la revendication précédente, **caractérisé en ce que** la masse composite (17) contient des particules d'argent, des particules de cuivre et/ou des particules de céramique, du gel de silice et/ou des combinaisons de ceux-ci.

9. Sous-ensemble semi-conducteur selon l'une des revendications 7 ou 8, **caractérisé en ce que**, dans la direction de projection sur le support de puce (10), la masse composite (17) est entièrement recouverte par la saillie (6) de l'optique secondaire (100).

10. Sous-ensemble semi-conducteur selon l'une des revendications 5 à 9, **caractérisé en ce que**

   a) l'au moins un composant semi-conducteur absorbant la lumière (2) comprend, au moins sur le côté relié avec l'optique secondaire (100), au moins un revêtement de protection, de préférence sélectionné dans le groupe constitué d'une couche métallique ; une couche d'oxyde, plus particulièrement d'oxyde d'aluminium et/ou une couche de matière plastique, comme un polyimide et/ou du PTFE,

b) l'optique secondaire (100) est mise en contact électrique avec l'au moins un composant semi-conducteur absorbant la lumière (2) et/ou

c) le sous-ensemble semi-conducteur est branché électriquement en série et/ou en parallèle avec au moins un autre sous-ensemble semi-conducteur par l'intermédiaire de l'au moins un contact.

11. Procédé de fabrication d'un sous-ensemble semi-conducteur selon l'une des revendications 5 à 10, **caractérisé en ce qu'**une optique secondaire selon l'une des revendications 1 à 4 est fixée sur un composant semi-conducteur absorbant la lumière (2) et/ou sur un support de puce (10).

12. Procédé selon la revendication précédente, comprenant les étapes suivantes :

a) application d'un collage (11) sur le composant semi-conducteur absorbant la lumière (2),
b) compression de l'optique secondaire (100) sur le composant semi-conducteur absorbant la lumière (2), de façon à ce qu'une distance entre 1 et 5 000 $\mu$m, de préférence de 5 à 1 000 $\mu$m, plus particulièrement de 10 à 300 $\mu$m, soit respectée entre l'optique secondaire (100) et le composant semi-conducteur absorbant la lumière (2),
c) enveloppement du composite fabriqué aux étapes a) et b) avec une masse composite (17) qui est ensuite durcie,

l'application du collage (11) ayant lieu de préférence au moyen d'un procédé par jet d'encre ou de processus de poinçonnage.

13. Procédé selon la revendication 11, **caractérisé en ce qu'**il comprend les étapes suivantes :

a) application d'une masse composite (17) autour du composant semi-conducteur absorbant la lumière (2) en laissant libre un évidement,
b) insertion et fixation de l'optique secondaire (100) dans l'évidement,

de préférence la masse de scellement étant appliquée sur le support de puce (10), sur lequel est disposé le composant semi-conducteur absorbant la lumière (2) et de préférence le fil de liaison (14), le dispositif de câblage (13) et/ou l'au moins une diode de protection étant englobés au moins partiellement dans la masse de scellement.

14. Procédé selon la revendication 13, **caractérisé en ce que** la fixation de l'optique secondaire (100) a lieu par friction statique et/ou grâce à l'ajout d'autres adhésifs sur les surfaces de contact entre l'optique secondaire (100) et l'évidement de la masse de scellement.

15. Procédé selon la revendication 11, **caractérisé en ce que**, sur le composant semi-conducteur absorbant la lumière (2), est appliqué un collage (11), l'optique secondaire (100) est comprimée sur l'emplacement revêtu de collage (11) sur le composant semi-conducteur absorbant la lumière (2) puis le moyen adhésif est durci.

# Stand der Technik

15

50

50

2

Fig.1a

2

Fig.1b

Fig.2a

Fig.2b

Fig.2c

Fig. 3a

Fig. 3b

200    100

6

A ⇈    ⇈ A

Fig. 4a

200    9    100    8    4    9'

16    3    5    16

16    13    16    2    10

Fig. 4b

300

15

200

200

200

200

12, 12'

200

200

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2007227573 A1
- US 5505789 A
- EP 0657948 A2
- WO 9118419 A
- US 5167724 A
- WO 2004077558 A1
- DE 19536454 A1
- DE 19947044 B4
- ES 2232299
- WO 2006130520 A2


**In der Beschreibung aufgeführte Nicht-Patentliteratur**

- **V. DIAZ ; J. ALAREZ ; J. ALONSO et al.** Assembly of Concentrator Modules based on Silicon Solar Cells at 300x of Concentrated Sunlight. *Proc. of 19th European Photovoltaic Solar Energy Conference,* 2004
- **L. M. FRAAS.** *Line-Fokus Photovoltaic Module Using Stacked Tandem-Cells,* 1994
- **J. JAUS ; U. FLEISCHFRESSER ; G. PEHARZ et al.** Heat Sink Substrates for Automated Assembly of Concentrator Modules. *Proc. of 21st European Photovoltaic Solar Energy Conference,* 2006, 2120-2123
- **A. W. BETT ; C. BAUR ; F. DIMROTH et al.** FLAT-CON™-modules: Technology and Characterisation. *Proc. of 3rd World Conference on Photovoltaic Energy Conversion,* 2003, 634-637